# EUROPÄISCHE PATENTSCHRIFT

(11) **EP 1 148 641 B1**
(45) Veröffentlichungstag und Bekanntmachung des Hinweises auf die Patenterteilung: **01.09.2010**
(21) Anmeldenummer: 01109562.7
(22) Anmeldetag: 18.04.2001
(51) Int. Cl.: H03J 1/00

(54) **Vorrichtung und Verfahren zur automatischen Auswahl von Sendern**
Device and method for automatic selection of emitters
Dispositif et procédé pour la sélection automatique d'émetteurs

(30) Priorität: 20.04.2000 DE 10019681
(43) Veröffentlichungstag der Anmeldung: 24.10.2001
(73) Patentinhaber: Delphi Technologies, Inc., Troy, MI 48098 (US)
(72) Erfinder: Horn, Georg, Grundig AG, 90471 Nürnberg (DE); Bienefeld, Axel, Grundig AG, 90471 Nürnberg (DE); Löhner, Thomas, Grundig AG, 90471 Nürnberg (DE)
(74) Vertreter: Denton, Michael John

(56) Entgegenhaltungen:
- EP-A- 0 866 576
- EP-A- 0 874 344
- EP-A- 0 964 514
- DE-A- 4 442 413
- PATENT ABSTRACTS OF JAPAN vol. 1995, no. 11, 26. Dezember 1995 (1995-12-26) & JP 07 202641 A (FUJITSU TEN LTD), 4. August 1995 (1995-08-04)

## Beschreibung

Die vorliegende Erfindung betrifft eine Vorrichtung und ein Verfahren zur automatischen Auswahl von Sendern, insbesondere von RDS/TMC-Sendern, für einen in einem Fahrzeug zu betreibenden Empfänger.

Bekannte Empfänger für Rundfunksignale in Fahrzeugen weisen Einrichtungen auf, die es ermöglichen, in den empfangbaren Rundfunksignalen enthaltene Zusatzdaten auszuwerten und dem Benutzer beispielsweise mittels einer Anzeige zugänglich zu machen. Ein gegenwärtig verwendetes derartiges System ist unter dem Kürzel RDS bekannt. RDS bedeutet Radio Daten System, wobei die von RDS-Sendern ausgestrahlten Rundfunksignale neben den üblichen Audiosignale digitale Zusatzsignale umfassen. Die digitalen Zusatzsignale beim RDS-System beinhalten beispielsweise eine Senderkennung Pl (Program Information), welche jede zusammengehörige Kette von RDS-Sender eindeutig kennzeichnet, sowie Informationen über das aktuelle Verkehrsgeschehen TMC (Traffic Message Channel) usw. Als Senderkennung Pl wird beispielsweise für den Sender "Bayern 3" das Kürzel "BR3" verwendet. Um das gesamte Sendegebiet abdecken zu können, wird eine Kette von RDS-Sendern mit unterschiedlicher Sendefrequenz verwendet, die ihre Rundfunksignale jeweils in einem Teilbereich des Sendegebiets ausstrahlen. Beispielsweise ist es mittels Auswertung der Senderkennung Pl "BR3" möglich, jeweils einen anderen RDS-Sender der Senderkette "Bayern 3" auszuwählen und den RDS-Empfänger auf die Sendefrequenz des jeweils anderen RDS-Senders abzustimmen, wenn der RDS-Empfänger aus dem Sendegebiet des RDS-Senders der Senderkette "Bayern 3" bewegt wird, dessen Empfangsfrequenz ursprünglich eingestellt war. Auf diese Weise wird gewährleistet, daß immer die gewünschte Senderkette "Bayern 3" empfangen wird.

Probleme können allerdings auftreten, wenn gleichzeitig neben dem Empfang der Audiosignale eines bestimmten Senders bzw. einer bestimmten Senderkette auch die Informationen über das aktuelle Verkehrsgeschehen TMC ausgewertet und dargestellt werden sollen. Diese Probleme resultieren daraus, daß die bestimmte Senderkette nicht unbedingt die Informationen über das Verkehrsgeschehen in seinen TMC-Signalen enthält, die für das Gebiet optimal geeignet sind, in dem sich der Empfänger jeweils aufhält. Derartige Probleme treten beispielsweise in Grenzgebieten verschiedener Senderketten auf. So kann im Grenzgebiet zwischen Bayern und Hessen, wenn das bayerische Gebiet verlassen wird, die Senderkette "Bayern 3" noch weit im hessischen Gebiet empfangen werden. Spezielle Informationen über das aktuelle Verkehrsgeschehen in Hessen sind allerdings nicht oder nur unzureichend in den TMC-Signalen der Senderkette "Bayern 3" enthalten.

Um nur Informationen über das Verkehrsgeschehen auszuwerten, die bezüglich des Aufenthaltsorts des Fahrzeugs relevant sind, schlägt die EP-A-0 866 576 eine automatische Aufenthaltsortbestimmung des Fahrzeugs nach dem Oberbegriff des Anspruchs 1 vor.

Die EP-A-0 964 514 offenbart einen Kraftfahrzeug-Radioempfänger mit einem Standortermittlungssystem, beispielsweise GPS, um bei einer längeren Fahrt durch mehrere (Bundes-)Staaten automatisch Radiosender einzustellen, die einem vom Fahrer gewünschten Programmprofil entsprechen. Zu diesem Zweck verwendet der Radioempfänger eine gespeicherte Tabelle mit Senderfrequenzen, Standorten und Programmprofilen.

Ein in der DE-A 44 42 413 offenbartes Verfahren zum Einstellen eines mobilen Rundfunkempfängers auf Sender mit für die jeweilige Position des Rundfunkempfängers relevanten Informationen ermittelt die jeweilige Position des Rundfunkempfängers und wählt anhand der ermittelten Position aus einer gespeicherten Liste entsprechende Sender aus.

Es ist daher Aufgabe der vorliegenden Erfindung, eine Vorrichtung und ein Verfahren zur automatischen Auswahl von Sendern, insbesondere von RDS Sendern, für einen in einem Fahrzeug zu betreibenden Empfänger anzugeben, bei denen die Sender jeweils derart ausgewählt werden, daß in den Rundfunksignalen der Sender enthaltene Informationen über das aktuelle Verkehrsgeschehen jeweils bestmöglich die Situation für das Gebiet widerspiegelt, in dem sich das Fahrzeug bzw. der im Fahrzeug betriebene Empfänger aufhält, ohne dabei eine durch einen Benutzer mögliche Senderauswahl einzuschränken.

Bei der vorliegenden Erfindung wird diese Aufgabe durch die Merkmale der Ansprüche 1 und 12 gelöst.

Bei der erfindungsgemäßen Vorrichtung und bei dem erfindungsgemäßen Verfahren zur automatischen Auswahl von Sendern, insbesondere von RDS/TMC-Sendern, für einen in einem Fahrzeug zu betreibenden Empfänger, wird dabei von der Überlegung ausgegangen, daß eine Steuereinheit mit zugehörigem Speicher Positionsdaten eines GPS-Decoders, insbesondere eines Navigationssystem, auswertet und in Abhängigkeit von den Positionsdaten nur diejenigen Sender anhand der Programm-Identifikation ausgewählt und nur die ortsabhängigen Daten eines RDS-Decoders zur Verfügung stellt, welche für die Positionsdaten relevant sind, wobei die Relevanz durch eine im Speicher gespeicherte Zuordnung von Positionsdaten zur Programm-Identifikation erkannt wird. Es ist ein zweiter Empfänger vorgesehen, um einem Benutzer zu ermöglichen, einen beliebigen Sender zu wählen, ohne dabei auf die Vorteile einer Auswertung von Verkehrsinformationen verzichten zu müssen.

Der Vorteil des erfindungsgemäßen Verfahrens bzw. der erfindungsgemäßen Vorrichtung ist darin zu sehen, daß zu jedem Zeitpunkt und an jeder Position Informationen über das aktuelle Verkehrsgeschehen im Bereich oder Gebiet der jeweiligen Position zur Verfügung stehen.

Besondere Vorteile ergeben sich, wenn den Positionsdaten mehrere relevante Programm-Identifikationen zugeordnet werden zugeordnet werden, insbesondere in Gebieten in denen mehrere aneinandergrenzende Sender unterschiedlicher Ketten mit unterschiedlichen ortsabhängigen Daten empfangen werden können. Somit ist es möglich Informationen über das aktuelle Verkehrsgeschehen in denGebieten der aneinandergrenzenden Sender zur Verfügung zu stellen.

Weitere Vorteile der vorliegenden Erfindung ergeben sich aus den abhängigen Ansprüchen sowie der nachfolgenden Beschreibung von Ausführungsbeispielen einer erfindungsgemäßen Vorrichtung anhand von Figuren.

Es zeigt:
- Fig. 1: eine Vorrichtung zur automatischen Auswahl von Sendern nach dem Stand der Technik,
- Fig. 2: ein Ausführungsbeispiel einer erfindungsgemäßen Vorrichtung zur auto- matischen Auswahl von Sendern, und
- Fig. 3: eine beispielhafte Darstellung von zwei aneinandergrenzenden Senderketten.

Zur Erleichterung des Verständnisses der vorliegenden Erfindung sind in den Figuren nur die Bestandteile der Ausführungsbeispiele dargestellt, die im Zusammenhang mit der Erfindung von Bedeutung sind. Gleiche Bestandteile in den Figuren weisen gleiche Bezugszeichen auf.

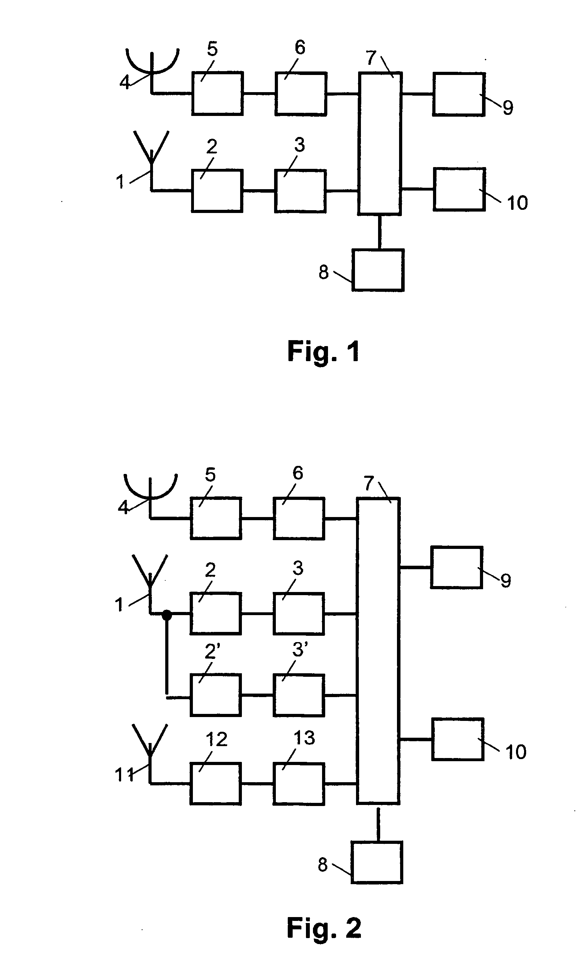

Figur 1 zeigt eine nicht beanspruchte Vorrichtung zur automatischen Auswahl von Sendern, für einen in einem Fahrzeug zu betreibenden Empfänger. Die Vorrichtung umfaßt einen RDS-Empfänger 1, 2, 3, ein Navigationssystem 4, 5, 6, eine Steuereinheit 7 mit zugehörigem Speicher 8 sowie eine Eingabeeinheit 9 und eine Ausgabeeinheit 10.

Der RDS-Empfänger 1, 2, 3 besteht beispielsweise aus einer Antenne 1, einem Tuner 2 und einem Decoder 3, welcher in Rundfunksignalen von RDS-Sendern enthaltene Zusatzdaten decodiert. Das Navigationssystem 4, 5, 6 umfaßt beispielsweise eine Antenne 4 für den Empfang von Satellitensignalen, einen GPS-Decoder 5, der aus Satellitensignalen des Global Positioning Systems Positionsangaben bestimmt, und eine Navigationseinheit 6, welche die Positionsangaben des GPS-Decoders 5 verwendet, um mittels in einem Speicher der Navigationseinheit 6, z. B. einem CD-ROM-Speicher, digital gespeicherter Straßenkarten die jeweilige Position der Vorrichtung bzw. des die Vorrichtung aufweisenden Fahrzeugs festzulegen und eine Routenplanung zu einem Zielort vorzunehmen. Die decodierten Zusatzdaten des RDS-Decoders 3, enthalten sender- und ortsabhängige Daten, beispielsweise Pl-Signale (senderabhängig) und TMC-Signale (ortsabhängig). Die ortsabhängigen TMC-Signale enthalten Informationen über das aktuelle Verkehrsgeschehen im Gebiet der jeweiligen Senderkette.

Die Zusatzdaten des RDS-Decoders 3 und die Positionsdaten der Navigationseinheit 6 werden an die Steuereinheit 7 übergeben, welche beispielsweise von einem Mikroprozessor mit zugehörigem Speicher 8 gebildet werden kann, und von der Steuereinheit 7 über die Ausgabeeinheit 10 einem Benutzer zugänglich gemacht. Die Ausgabeeinheit 10 kann beispielsweise eine Anzeige sein, die graphische und alphanumerische Darstellungen anzeigen kann, z. B. ein LC-Display. Die Eingabeeinheit 9 wird mittels Tasten gebildet, die es ermöglichen z. B. den Zielort einzugeben, für den das Navigationssystem 4, 5, 6 eine Route planen soll.

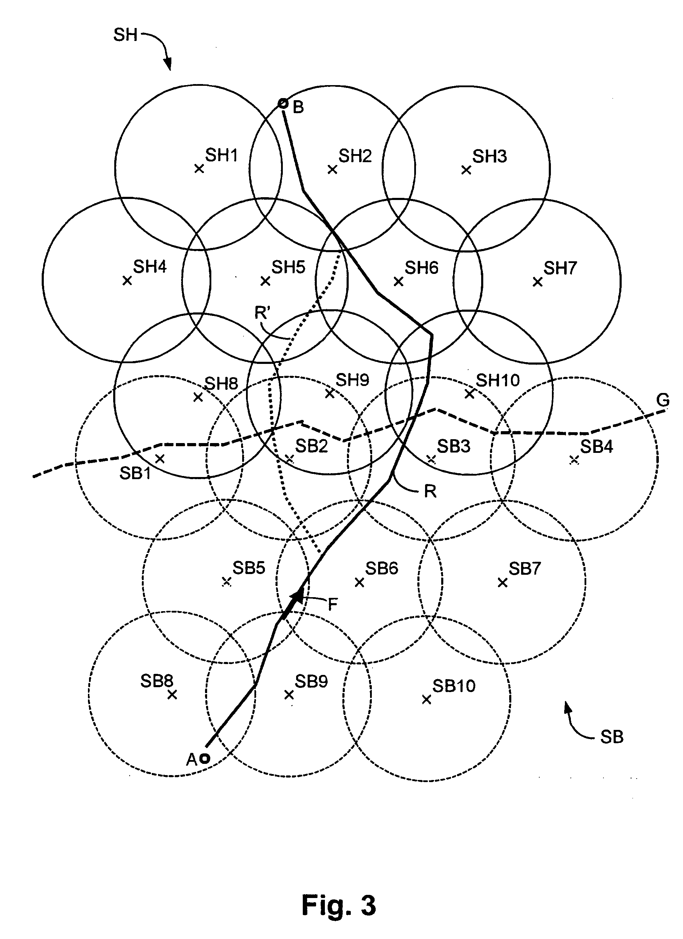

In Figur 3 ist beispielhaft die Situation für zwei Gebiete mit aneinandergrenzenden Senderketten dargestellt. Eine erste Senderkette SB mit Sendern SB1 bis SB10 grenzt entlang einer Grenzlinie G an eine zweite Senderkette SH mit Sendern SH1 bis SH10. Jeder der Sender SB1 bis SB10 der ersten Senderkette SB sowie jeder der Sender SH1 bis SH10 der zweiten Senderkette SH weist unterschiedliche Sendefrequenzen auf, so daß aneinandergrenzende Sender sich nicht gegenseitig durch Interferenzen stören. Dabei kann es ausreichend sein, wenn pro Senderkette z. B. vier verschiedene Sendefrequenzen zur Verfügung stehen, die mit entsprechendem Abstand voneinander für die einzelnen Sender verwendet werden. Abweichend von der dargestellten Situation der Abgrenzung der Sendegebiete der einzelnen Sender ist anzumerken, daß die Sender unter Umständen noch weit außerhalb der gezeigten Begrenzungen durch Kreise empfangen werden können.

Wird ein Fahrzeug F, welches die oben beschriebene Vorrichtung enthält, entlang einer Route R von Punkt A nach Punkt B bewegt, werden die Sendegebiete von mehreren der Sender SB1 bis SB10 sowie SH1 bis SH10 vom Fahrzeug F durchfahren. An der in der Figur 3 für das Fahrzeug F dargestellten momentanen Position ist sowohl der Sender SB5 als auch der Sender SB6 zu empfangen.

Die Auswahl des Senders bzw. seiner Sendefrequenz erfolgt durch die Steuereinheit 7, welche dazu die Positionsdaten der Navigationseinheit 6 auswertet. Diese Positionsdaten werden mit im Speicher 8 gespeicherten Daten verglichen, welche Informationen darüber enthalten, welche Senderketten in Regionen zu empfangen sind. Die einzelnen Sender bzw. Senderketten werden dabei beispielsweise mittels der RDS-Senderkennung Pl identifiziert. Ebenso ist es möglich, daß in den TMC-Signalen enthaltene Ortsangaben gefiltert werden. Derartige Ortsangaben in den TMC-Signalen werden beispielsweise dazu verwendet, Positionen (Locations) anzugeben an denen das aktuelle Verkehrsgeschehen gestört ist. Da für alle Sender SB1 bis SB10 sowie SH1 bis SH10 im Speicher 8 Informationen darüber abgelegt sind, welche Sendefrequenz der jeweilige Sender hat und innerhalb welchen Gebiets bzw. an welchen Positionen der jeweilige Sender zu empfangen ist, kann die Steuereinheit 7 durch die Auswertung der Positionsdaten den jeweils geeignetsten Sender mit TMC-Signal auswählen. Im dargestellten Beispiel wird somit der Sender SB6 durch die Steuereinheit 7 ausgewählt. Die im Speicher 8 ebenfalls enthaltene Sendefrequenz des Senders SB6 wird durch die Steuereinheit 7 am Tuner 2 eingestellt und bildet dessen Empfangsfrequenz, so daß der Sender SB6 empfangen wird.

In einer Weiterbildung der Erfindung ist vorgesehen, daß anhand einer im Speicher bereits vorhandenen Liste mit empfangbaren Senderketten die jeweiligen Positionsdaten der Sender angegeben sind und die Vorrichtung anhand dieser Liste die empfangbaren Senderketten ermittelt. Die Liste kann in den Speicher 8 übertragen werden über die Navigationseinheit 6 mit angeschlossenen und/oder zugehörigem Speichermedium wie z.B. DVD, CD-ROM, Chip-Karte, Multimedia-Karte oder über einen Internetzugang, welcher mittels der Komponenten des Navigationseinheit und des Mobiltelefons 12 ermöglicht wird. Im Falle des Internetzugangs ermittelt die Steuereinheit 7 anhand einer vordefinierten Adresse im Internet die notwendigen Daten, welche dort zu Download bereit liegen.

Wird das Fahrzeug F weiter in Richtung zum Zielort B bewegt, werden laufend die Positionsdaten durch die Steuereinheit 7 ausgewertet und mit den im Speicher 8 gespeicherten Daten verglichen. Auf diese Weise kann zu jedem Zeitpunkt und an jeder Position des Fahrzeugs F ein geeigneter Sender durch die Steuereinheit 7 gewählt werden und die Sendefrequenz des gewählten Senders am Tuner 2 als Empfangsfrequenz eingestellt werden.

Zusätzlich zur Auswertung der TMC-Signale der Sender einer Senderkette innerhalb eines Sendegebiets, z. B. Sendekette SB, können TMC-Signale weiterer Sender bzw. Senderketten ausgewertet werden, die ebenfalls für das Gebiet der Senderkette SB ausgestrahlt werden und deren Daten im Speicher 8 enthalten sein können. Die Zuordnung weiterer Sender bzw. Senderketten erfolgt ebenfalls über die RDS-Senderkennung Pl oder die Ortsangaben der TMC-Signale. Derartige weitere Sender bzw. Senderketten sind aus Gründen der Übersichtlichkeit nicht dargestellt. Falls mehrere Senderketten empfangbar sind, kann es auch vorgesehen sein, daß es dem Benutzer ermöglicht wird, eine bevorzugte Senderkette mittels der Eingabeeinheit 9, generell oder für einen bestimmten Bereich, auszuwählen.

Die oben beschriebene Vorgehensweise kann prinzipiell zwei verschiedene Modi aufweisen, die von der Betriebsart des Navigationssystems 4, 5, 6 abhängen. Dabei ist zu unterscheiden, ob die Zielführung des Navigationssystems 4, 5, 6 deaktiviert oder aktiviert ist, d. h. ob der Benutzer sich durch das Navigationssystem 4, 5, 6 eine Route bestimmen läßt oder nicht.

Bei deaktivierter Zielführung des Navigationssystems 4, 5, 6 werden die RDS-Sender mit TMC-Signal der jeweils befahrenen Region aufgrund der Auswertung der jeweiligen Positionsdaten des Navigationssystems 4, 5, 6 ausgewählt und deren TMC-Signale ausgewertet. Für die in Figur 3 dargestellte Position des Fahrzeugs F bedeutet dies, daß neben dem Sender SB6 auch die Sender SB5 und SB9 am Tuner 2 von der Steuereinheit 7 eingestellt werden und die TMC-Signale dieser Sender zusätzlich ausgewertet werden. Setzt das Fahrzeug F, ausgehend von der dargestellten Position, die Route R in Richtung B fort, wird bei Erreichen des Rands des Sendegebiets des Senders SB6 zusätzlich zum TMC-Signal des Senders SB6 das TMC-Signal des Senders SB2 und des Senders SB3 ausgewertet. Dazu wird die Empfangsfrequenz des Tuners 2 von der Steuereinheit 7 abwechselnd auf die Sendefrequenzen der Sender SB6, SB2 und SB3 eingestellt, die im Speicher 8 der Steuereinheit 7, zusammen mit den entsprechenden Positionsangaben gespeichert sind.

Wie oben beschrieben können zusätzlich die TMC-Signale anderer Sender, die zu einer anderen, in der Figur 3 nicht dargestellten, Senderkette gehören und im selben Gebiet ausgestrahlt werden, ausgewertet werden.

Es besteht die Möglichkeit daß ein Nutzer individuell einen Sender mit TMC-Signalen einstellen kann. Dies ist vor allem dann sinnvoll wenn z.B. ein lokaler Rundfunksender für die zugehörige Umgebung genauere und "bessere" TMC-Daten zur Verfügung stellt und ein Nutzer diese Daten verwenden will.

Ebenso ist es möglich, nicht nur die TMC-Signale der in unmittelbarer Nähe des jeweiligen Senders liegenden anderen Senderketten auszuwerten, sondern alle angrenzenden Senderketten. Dann werden, falls die Sender dieser Senderketten oder zumindest ein Sender dieser Senderkette, an der jeweiligen Position des Fahrzeugs F empfangen werden können.

Besonders vorteilhaft wird die beschriebene Auswertung der TMC-Signale mehrerer Sender bei Erreichen der Grenzlinie G zwischen den verschiedenen Gebieten der Senderketten SB und SH. Erreicht das Fahrzeug F beispielsweise das Sendegebiet des Senders SB3, der Bestandteil der ersten Senderkette SB ist, wird aufgrund der Positionsdaten des Navigationssystems 4, 5, 6 erkannt, daß unter Umständen ein Wechsel in das Gebiet der zweiten Senderkette SH bevorsteht. Zusätzlich werden deshalb z. B. die Sendefrequenzen der Senderkette SH durch die Steuereinheit 7 am Tuner 2 als Empfangsfrequenzen eingestellt und die TMC-Signale ausgewertet. Dies ist besonders vorteilhaft, wenn eine Strecke befahren wird, die über eine längere Strecke im Bereich der Grenzlinie G verläuft, weil dann immer die Informationen über das Verkehrsgeschehen aus den TMC-Signalen beider Senderketten SB und SH zur Verfügung stehen.

Im weiteren schätzt die Steuereinheit 7 anhand der zurückgelegten Wegstrecke die weitere Fahrtrichtung des Fahrzeuges F ab und ermittelt vorausschauend weitere neue TMC-Sender, welche für die weitere Fahrtstrecke relevante Daten liefern. Diese TMC-Sender speichert die Steuereinheit 7 im Speicher 8 ab.

Bei aktivierter Zielführung des Navigationssystems 4, 5, 6 werden die RDS-Sender mit TMC-Signal der jeweils befahrenen Region aufgrund der Auswertung der jeweiligen Positionsdaten des Navigationssystems 4, 5, 6 ausgewählt und deren TMC-Signale ausgewertet, wobei zusätzlich auch die aus dem Navigationssystem 4, 5, 6 zur Verfügung stehende Information über die geplante Route R ausgewertet werden kann. Dazu wurde vom Benutzer angeben, von welchem Ausgangsort A er zu dem Zielort B gelangen möchte. Die günstigste Route R wird vom Navigationssystem 4, 5, 6 bestimmt. Während der Fahrt entlang der Route R kann dann jeweils die am besten geeignet Senderkette ausgewählt werden. Für die in Figur 3 dargestellte Position des Fahrzeugs F ist dies die Senderkette SB mit dem Snder SB6. Da durch die Zielbestimmung die weitere Fahrtstrecke bekannt ist, kann in einer weiteren Vorausschau die Steuereinheit 7 die nächste Senderkette SH einstellen, in deren Sendebereich die Fahrtroute weiter verläuft. Die Steuereinheit 7 wird nunmehr den Tuner 2 auf die Sendefrequenz der Senderkette SH, insbesondere den Senders SH 10, abstimmen um möglichst frühzeitig TMC-Informationen für die weitere Route zu empfangen und auszuwerten.

Wie oben beschrieben können zusätzlich die TMC-Signale anderer Senderketten, welche im selben Gebiet ausgestrahlt werden, ausgewertet werden.

Auf diese Weise können alle Senderketten (SH, SB), die entlang der geplanten Route R liegen, nämlich mit den Sendern SB8, SB9, SB6, SB3, SHIO, SH6 und SH2, sehr frühzeitig ausgewertet werden, d. h. sobald sie empfangbar sind. Damit ist es möglich, daß Störungen im Verkehrsfluß, die, ausgehend von der dargestellten Position des Fahrzeugs F im Gebiet des Senders SB6, beispielsweise erst im Gebiet der Senderkette SH liegen, so frühzeitig erkannt werden, daß die in den TMC-Signalen der Senderkette SH enthaltenen Informationen ausgewertet werden und bei der Zielführung berücksichtigt werden können. In diesem Fall kann beispielsweise eine Ausweichroute R' berechnet werden, welche die Störungen umgeht. Entsprechend werden dann die Sender SB2, SH9 und SH5 durch die Steuereinheit 7 ausgewählt.

Abweichend von der oben beschriebenen Auswahl jeweils nur der Sender durch die Steuereinheit 7, die in Bezug auf die jeweiligen Positionsdaten von Bedeutung sind, kann es auch vorgesehen sein, zuerst alle empfangbaren Sender mit ortsabhängigen Zusatzinformationen, wie z. B. TMC-Signalen, zu empfangen und die TMC-Signale sowie die Senderkennung P1 im Speicher 8 abzuspeichern. Von den abgespeicherten Daten werden dann nur diejenigen von der Steuereinheit 7 zur weiteren Verarbeitung zur Verfügung gestellt, welche aufgrund der Positionsdaten der Navigationseinheit 6 durch die Steuereinheit 7 als relevant eingestuft werden. Dazu bedient sich die Steuereinheit der Daten im Speicher 8, wie sie oben beschrieben wurden, welche einen Zusammenhang zwischen Positionsdaten und Sendern herstellen, also entweder der Pl-Signale oder der in den TMC-Signalen enthaltenen Ortsangaben (Locations).

Figur 2 zeigt ein Ausführungsbeispiel einer erfindungsgemäßen Vorrichtung zur automatischen Auswahl von Sendern und Senderketten, für einen in einem Fahrzeug zu betreibenden Empfänger. Die Vorrichtung ist im wesentlichen entsprechend der in Figur 1 dargestellten Vorrichtung aufgebaut. Zusätzlich weist die Vorrichtung jedoch einen zweiten RDS-Empfänger 2', 3' auf, der einen Tuner 2' und einen RDS-Decoder 3' umfaßt, sowie ein Funkempfänger II, 12, 13. Der Funkempfänger 11, 12, 13 kann beispielsweise von einem Mobiltelefon nach dem GSM-Standard gebildet werden und eine Antenne 11, das eigentliche Mobiltelefon 12 sowie eine Schnittstelle 13 aufweisen, die das Mobiltelefon 12 mit der Steuereinheit 7 verbindet.

Durch den zweiten RDS-Empfänger 2', 3' wird es beispielsweise möglich, daß der Benutzer einen beliebigen Sender bzw. eine beliebige Senderkette einstellt und sich dessen Audiosignal wiedergeben läßt. Die für die vorliegende Erfindung nötige Auswertung der Pl- und TMC-Signale verschiedener Sender oder Senderketten erfolgt dann, wie oben beschrieben, mittels des ersten RDS-Empfängers 2, 3.

Das Mobiltelefon 12 kann beispielsweise dazu benutzt werden, die oben beschriebenen und im Speicher 8 gespeicherten Daten, welche den Zusammenhang zwischen einzelnen Sendern bzw. Senderketten und ihrer Position enthalten, von einem Telematikdienst durch die Steuereinrichtung 7 anzufordern. Der Telematikdienst überträgt die Daten über die Funkverbindung. Abweichend davon können diese Daten auch Bestandteil der oben beschriebenen Daten des Navigationssystems 4, 5, 6 sein und beispielsweise auf der ebenfalls oben erwähnten CD-ROM gespeichert sein.

Weitere Abweichungen von den beschriebenen Ausführungsformen können beispielsweise für das Navigationssystem vorgesehen werden, z. B. können statt oder zusätzlich zu einem GPS-System 4, 5 Radsensoren verwendet werden, deren Signale durch die Navigationseinheit 6 ausgewertet werden.

Ebenso kann es vorgesehen sein, daß die Steuereinheit 7 mit zugehörigem Speicher 8 kein separates Bauteil ist, sondern in der Navigationseinheit 6 oder im RDS-Empfänger 2, 3 enthalten sein. Die Steuereinheit 7 mit Speicher 8 kann auch von einem anderen geeigneten Gerät gebildet werden, das im Fahrzeug F ohnehin vorhanden ist, beispielsweise einem Bordcomputer.

Die Eingabeeinheit 9 und die Ausgabeeinheit 10 können eine bauliche Einheit bilden und beispielsweise mittels eines Touchscreen-Display realisiert werden. Ebenso können Eingabeeinheit 9 und Ausgabeeinheit 10 Bestandteil der Navigationseinheit 6, des RDS-Empfängers 2, 3 oder eines Bordcomputers sein. Um die Ablenkung eins Benutzers durch die Eingabeeinheit 9 und die Ausgabeeinheit 10 zu minimieren kann es weiterhin vorgesehen sein, daß die Eingabeeinheit 9 eine Sprachsteuerung umfaßt und die Ausgabeeinheit 10 eine akustische Ausgabe aufweist.

Abweichend von der oben beschriebenen Realisierung der erfindungsgemäßen Vorrichtung im Zusammenhang mit RDS-Sendern und RDS-Empfängern ist offensichtlich, daß die Erfindung überall dort Anwendung finden kann, wo es, abhängig von einer Momentanposition, wichtig ist, einen geeigneten Sender auszuwählen. Somit ist die Anwendung der oben beschriebenen Erfindung auch im Zusammenhang mit DAB-Sendern und DAB-Empfängern (Digital Audio Broadcast) sowie DGPS-Sendern und DGPS-Empfängern (Differential Global Positioning System) von Vorteil. DAB-Sendern und DAB-Empfängern arbeiten nach dem Digital Audio Broadcast Standard und dienen der digitalen Ausstrahlung von Rundfunksignalen. DGPS-Sendern und DGPS-Empfängern dienen der Verbesserung von GPS-Positionierungssystemen durch die zusätzliche Verwendung terrestrischer Sender.

### Bezugszeichenliste

- 1: Antenne
- 2: Tuner
- 2': Tuner
- 3: Decoder
- 3': Decoder
- 4: Antenne
- 5: GPS-Decoder
- 6: Navigationseinheit
- 7: Steuereinheit
- 8: Speicher
- 9: Eingabeeinheit
- 10: Ausgabeeinheit
- 11: Antenne
- 12: Mobiltelefon
- 13: Schnittstelle

- F: Fahrzeug
- SB1 bis SB10: Sender der Senderkette SB
- SH1 bis SH10: Sender der Senderkette SH
- G: Grenzlinie

## Patentansprüche

1. Vorrichtung zur automatischen Auswahl von Sendern und/oder Senderketten, deren Signale sender- und ortsabhängige Daten (P1, TMC) beinhalten, insbesondere von RDS-Sendern, für einen in einem Fahrzeug zu betreibenden Empfänger, mit
einem Empfänger (1, 2, 3), der einen Decoder (3) für die Decodierung der sender- und ortsabhängigen Daten umfaßt, und
einem Navigationssystem (4, 5, 6),
wobei eine Steuereinheit (7) mit zugehörigem Speicher (8) Positionsdaten eines GPS-Decoders (5), insbesondere eines Navigationssystems (4, 5, 6), auswertet und in Abhängigkeit von den Positionsdaten senderabhängigen Daten (P1) nur diejenigen sender- und ortsabhängigen Daten (P1, TMC) des Decoders (3) zur Verfügung stellt, welche für die Positionsdaten relevant sind, wobei im Speicher (8) eine Zuordnung von Positionsdaten zu senderabhängigen Daten (P1, TMC) gespeichert ist,
**dadurch gekennzeichnet, daß**
die Vorrichtung einen zweiten Empfänger (2', 3') umfaßt, um es einem Benutzer zu ermöglichen, parallel zur Auswertung der P1- und TMC-Signale verschiedener Sender oder Senderketten einen beliebigen Sender bzw. eine beliebige Senderkette einzustellen und sich dessen Audiosignal wiedergeben zu lassen.

2. Vorrichtung nach Anspruch 1,
**dadurch gekennzeichnet, daß**
die im Speicher (8) gespeicherte Zuordnung von Positionsdaten zu sender- und ortsabhängigen Daten (P1, TMC) für mindestens ein Positionsdatum oder Areal mindestens einen oder mehrere sender- und ortsabhängige Daten (P1, TMC) umfaßt.

3. Vorrichtung nach Anspruch 2,
**dadurch gekennzeichnet, daß**
der Speicher (8) ein RAM, ROM, Flash, ein CDRW-, ein CD-ROM-, ein DVD-, ein DVD-RW-Laufwerk, eine Chip-Karte oder eine Multimedia-Karte ist.

4. Vorrichtung nach Anspruch 2,
**dadurch gekennzeichnet, daß**
die Einspeicherung von Daten in den Speicher (8) über die Navigationseinheit (6), die Steuereinheit (7), einen angeschlossenen Personal-Digital-Assitent, einen DAB-Empfänger, ein Programmiergerät, einen BUS-Anschluß oder über einen Onlinezugang zum Internet erfolgt.

5. Vorrichtung nach Anspruch 1 oder 2,
**dadurch gekennzeichnet, daß**
die Steuereinheit (7) alle empfangbaren Sender **dadurch** auswählt, daß sie den Empfänger (1, 2, 3) auf entsprechende Empfangsfrequenzen einstellt, und sämtliche vom Decoder (3) stammende sender- und/ oder ortsabhängigen Daten (P1, TMC) aller empfangbaren Sender in ihrem Speicher (8) speichert und/oder die Steuereinheit (7) alle empfangbaren Sender mit sender- und/oder ortsabhängigen Daten (P1, TMC) anhand einer im Speicher (8) vorhandenen Tabelle und den aktuell ausgewerteten GPS-Daten ermittelt und/oder die Steuereinheit (7) nur denjenigen oder diejenigen Sender **dadurch** auswählt, daß sie den Empfänger (1, 2, 3) auf eine entsprechende Empfangsfrequenz oder auf entsprechende Empfangsfrequenzen einstellt, der oder die aufgrund der Zuordnung der Positionsdaten zu den sender- und ortsabhängigen Daten (P1, TMC) relevant ist oder sind.

6. Vorrichtung nach einem der Ansprüche 1 bis 5,
**dadurch gekennzeichnet, daß**
die Steuereinheit (7) zusätzlich zu den Positionsdaten des Navigationssystems (4, 5, 6) auch eine durch das Navigationssystem (4, 5, 6) bestimmte Route (R) auswertet, um die sender- und ortsabhängigen Daten (P1, TMC) des Decoders (3) zur Verfügung zu stellen.

7. Vorrichtung nach einem der Ansprüche 1 bis 5,
**dadurch gekennzeichnet, daß**
die Steuereinheit (7) zusätzlich zu den Positionsdaten des Navigationssystems (4, 5, 6) auch eine durch das Navigationssystem (4, 5, 6) bestimmte Route (R) auswertet, um die sender- und ortsabhängigen Daten (P1, TMC) des Decoders (3) vorausschauend zur Verfügung zu stellen oder die Steuereinheit (7) bei deaktiviertem Navigationssystem (4, 5, 6) anhand einer Fahrtroutenabschätzung anhand der bisherig zurückgelegten Fahrtstrecke die sender- und ortsabhängigen Daten (P1, TMC) des Decoders (3) vorausschauend zur Verfügung stellt.

8. Vorrichtung nach einem der Ansprüche 1 bis 7,
**dadurch gekennzeichnet, daß**
die ortsabhängigen Daten (TMC) vom Navigationssystem (4, 5, 6) bei der Bestimmung von Routen (R') berücksichtigt werden.

9. Vorrichtung nach einem der Ansprüche 1 bis 7,
**gekennzeichnet durch**
einen Funkempfänger (11, 12, 13) zur Übertragung der im Speicher (8) gespeicherten Zuordnung von Positionsdaten zu senderabhängigen Daten (P1).

10. Vorrichtung nach einem der Ansprüche 1 bis 9,
**dadurch gekennzeichnet, daß**
die Zuordnung von Positionsdaten zu senderabhängigen Daten (P1, TMC) im Navigationssystem (4, 5, 6) gespeichert ist.

11. Vorrichtung nach einem der Ansprüche 1 bis 10,
**dadurch gekennzeichnet, daß**
das Navigationssystem (4, 5,6) einen GPS-Decoder (5) aufweist.

12. Verfahren zur automatischen Auswahl von Sendern, deren Signale sender-und ortsabhängige Daten (P1, TMC) beinhalten, insbesondere von RDS-Sendern, für einen in einem Fahrzeug zu betreibenden Empfänger, mit nachfolgenden Verfahrensschritten:
- Bereitstellen einer Zuordnung von Positionsdaten zu sender abhängigen Daten (P1),
- Ermitteln von Positionsdaten, die der jeweiligen Position des Fahrzeugs entsprechen, und
- Zur Verfügung stellen von denjenigen sender- und ortsabhängigen Daten (P1, TMC) der Sender, welche für die ermittelten Positionsdaten relevant sind, **dadurch gekennzeichnet, daß**
parallel zu der Verfügungsstellung derjenigen sender- und ortsabhängigen Daten (P1, TMC) der Sender, welche für die ermittelten Positionsdaten relevant sind, ein beliebiger Sender bzw. eine beliebige Senderkette eingestellt wird und dessen Audiosignal wiedergegeben wird.

13. Verfahren nach Anspruch 12,
**dadurch gekennzeichnet, daß**
die bereitgestellte Zuordnung von Positionsdaten zu sender abhängigen Daten (P1 für mindestens ein Positionsdatum mehrere senderabhängige Daten (P1) umfaßt.

14. Verfahren nach Anspruch 12 oder 13,
**dadurch gekennzeichnet, daß**
alle empfangbaren Sender ausgewählt werden und sämtliche sender- und ortsabhängigen Daten (P1, TMC) der empfangbaren Sender zwischengespeichert werden.

15. Verfahren nach Anspruch 12,
**dadurch gekennzeichnet, daß**
nur derjenige oder diejenigen Sender ausgewählt wird oder werden, der oder die aufgrund der Zuordnung der Positionsdaten zu den sender- und ortsabhängigen Daten (P1, TMC) relevant ist oder sind und/oder für die Route relevant ist oder sind.

## Claims

1. Device for automatic selection of transmitters and/or transmitter chains, whose signals include transmitter and location dependent data (P1, TMC), in particular of RDS transmitters, for a receiver to be operated in a vehicle, comprising
a receiver (1, 2, 3), including a decoder (3) for decoding the transmitter and location dependent data, and
a navigation system (4, 5, 6),
wherein a control unit (7) having associated memory (8) evaluates position data of a GPS decoder (5), in particular of a navigation system (4, 5, 6), and provides only those transmitter and location dependent data (P1, TMC) of the decoder (3), depending on the position data transmitter dependent data (P1), which are relevant to the position data, wherein an association of position data to transmitter dependent data (P1, TMC) is stored in the memory (8),
**characterized in that**
the device includes a second receiver (2', 3') to enable a user to set a desired transmitter or a desired transmitter chain and to play their audio signal in parallel to the evaluation of the P1 and TMC signals of various transmitters or transmitter chains.

2. The method according to claim 1,
**characterized in that**
the association of position data to transmitter and location dependent data (P1, TMC) for at least a position date or area, stored in memory (8), includes at least one or more transmitter and location dependent data (P1, TMC).

3. The method according to claim 2,
**characterized in that**
the memory (8) is a RAM, ROM, Flash, a CDRW, a CD-ROM, a DVD, a DVD-RW drive, a chip card or a multimedia card.

4. The method according to claim 2,
**characterized in that**
storing of data into the memory (8) is performed through the navigation unit (6), the control unit (7), a connected personal digital assistant, a DAB receiver, a programming device, a bus connection or through an online access to the Internet.

5. The method according to claim 1 or 2,
**characterized in that**
the control unit (7) selects all receivable transmitters by setting the receiver (1, 2, 3) to corresponding receiving frequencies, and stores all transmitter and/or location dependent data (P1, TMC), originating from the decoder (3), of all available transmitters in its memory (8) and/or the control unit (7) detects all receivable transmitters with transmitter and/or location dependent data (P1, TMC) using a table in the memory (8) and the currently evaluated GPS data and/or the control unit (7) selects only those transmitter or transmitters by setting the receiver (1, 2, 3) to an appropriate receiving frequency or appropriate receiving frequencies, which is/are relevant based on the association of the position data to the transmitter and location dependent data (P1, TMC).

6. The method according to one of the claims 1 to 5,
**characterized in that**
the control unit (7), in addition to the position data of the navigation system (4, 5, 6), also evaluates a route (R) determined by the navigation system (4, 5, 6) to provide the transmitter and location dependent data (P1, TMC) of the decoder (3).

7. The method according to one of the claims 1 to 5,
**characterized in that**
the control unit (7), in addition to the position data of the navigation system (4, 5, 6), also evaluates a route (R) determined by the navigation system (4, 5, 6) to provide the transmitter and location dependent data (P1, TMC) of the decoder (3) predictively, or the control unit (7) provides predictively, upon disabled navigation system (4, 5, 6), the transmitter and location dependent data (P1, TMC) of the decoder (3) using a travel route estimate based on the earlier traveled route.

8. The method according to one of the claims 1 to 7,
**characterized in that**
the location dependent data (TMC) of the navigation system (4, 5, 6) are considered in the determination of routes (R').

9. The method according to one of the claims 1 to 7,
**characterized by**
a radio receiver (11, 12, 13) for transmission of the association of position data to transmitter dependent data (P1) stored in memory (8).

10. The method according to one of the claims 1 to 9,
**characterized in that**
the association of position data to transmitter dependent data (P1, TMC) is stored in the navigation system (4, 5, 6).

11. The method according to one of the claims 1 to 10,
**characterized in that**
the navigation system (4, 5, 6) comprises a GPS decoder (5).

12. Method for automatic selection of transmitters, whose signals include transmitter and location dependent data (P1, TMC), in particular of RDS transmitters, for a receiver to be operated in a vehicle, comprising the following method steps:
- providing an association of position data to transmitter dependent data (P1),
- detecting of position data corresponding to the respective position of the vehicle, and
- providing of those transmitter and location dependent data (P1, TMC) of the transmitters which are relevant for the determined position data,
**characterized in that**,
parallel to providing those transmitter and location dependent data (P1, TMC) of the transmitters, which are relevant for the determined position data, any transmitter or any transmitter chain is set and its/their audio signal is played.

13. The method according to claim 12,
**characterized in that**
the provided association of position data to transmitter dependent data (P1) includes several transmitter dependent data (P1) for at least one position date.

14. The method according to claim 12 or 13,
**characterized in that**
all receivable transmitters are selected and all transmitter and location dependent data (P1, TMC) of the receivable transmitters are cached.

15. The method according to claim 12,
**characterized in that**
only that or those transmitter(s) is/are selected, which is/are relevant based on the association of the position data to the transmitter and location dependent data (P1, TMC) and/or is/are relevant for the route.

## Revendications

1. Dispositif pour la sélection automatique d'émetteurs et/ou de chaînes d'émetteurs, dont les signaux contiennent des données (P1, TMC) qui dépendent de l'émetteur et du lieu, en particulier d'émetteurs RDS, pour un récepteur destiné à fonctionner dans un véhicule automobile, comprenant
un récepteur (1, 2, 3) qui inclut un décodeur (3) pour le décodage des données qui dépendent de l'émetteur et du lieu, et
un système de navigation (4, 5, 6),
dans lequel une unité de commande (7) avec mémoire associée (8) évalue des données de position d'un décodeur GPS (5), en particulier d'un système de navigation (4, 5, 6) et, en fonction des données de position parmi les données (P1) qui dépendent de l'émetteur, met à disposition uniquement celles des données (P1, TMC), qui dépendent de l'émetteur et du lieu, du décodeur (3) qui sont pertinentes pour les données de position, et une association des données de position vis-à-vis de données (P1, TMC) qui dépendent de l'émetteur est mémorisée dans la mémoire (8),
**caractérisé en ce que**
le dispositif comprend un second récepteur (2', 3') afin de permettre à un utilisateur de régler, parallèlement à l'évaluation des signaux P1 et TMC de différents émetteurs ou de différentes chaînes d'émetteurs, un émetteur ou une chaîne d'émetteurs quelconque, et de faire reproduire son signal audio.

2. Dispositif selon la revendication 1,
**caractérisé en ce que** l'association, mémorisée dans la mémoire (8), de données de position vis-à-vis de données (P1, TMC) qui dépendent de l'émetteur et du lieu, inclut au moins une ou plusieurs données (P1, TMC) qui dépendent de l'émetteur et du lieu pour au moins une donnée de position ou une zone.

3. Dispositif selon la revendication 2,
**caractérisé en ce que** la mémoire (8) est une mémoire RAM, ROM, Flash, un lecteur pour disques CDRW, CD-ROM, DVD, DVD-RW, une carte à puce ou une carte multimédia.

4. Dispositif selon la revendication 2,
**caractérisé en ce que** la mémorisation de données dans la mémoire (8) a lieu via l'unité de navigation (6), l'unité de commande (7), un assistant numérique personnel raccordé, un récepteur DAB, un appareil de programmation, un raccord de BUS, ou un accès en ligne à l'Internet.

5. Dispositif selon la revendication 1 ou 2,
**caractérisé en ce que** l'unité de commande (7) sélectionne tous les émetteurs susceptibles d'être reçus en réglant le récepteur (1, 2, 3) à des fréquences de réception correspondantes, et mémorise dans sa mémoire (8) la totalité des données (P1, TMC) qui dépendent de l'émetteur et/ou du lieu en provenance du décodeur (3) pour tous les émetteurs susceptibles d'être reçus et/ou en ce que l'unité de commande (7) détermine tous les émetteurs susceptibles d'être reçus avec des données (P1, TMC) qui dépendent de l'émetteur et/ou du lieu au moyen d'un tableau présent dans la mémoire (8) et des données GPS actuelles évaluées et/ou **en ce que** l'unité de commande (7) sélectionne uniquement l'émetteur ou les émetteurs concerné(s) en établissant le récepteur (1, 2, 3) à une ou à des fréquence(s) de réception correspondante(s) qui est/sont pertinente(s) en raison de l'association des données de position vis-à-vis des données (P1, TMC) qui dépendent de l'émetteur et du lieu.

6. Dispositif selon l'une des revendications 1 à 5,
**caractérisé en ce que** l'unité de commande (7) évalue, additionnellement aux données de position du système de navigation (4, 5, 6), également un itinéraire (R) déterminé par le système de navigation (4, 5, 6) pour mettre à disposition les données (P1, TMC), qui dépendent de l'émetteur et du lieu, du décodeur (3).

7. Dispositif selon l'une des revendications 1 à 5,
**caractérisé en ce que** l'unité de commande (7) évalue, additionnellement aux données de position du système de navigation (4, 5, 6), également un itinéraire (R) déterminé par le système de navigation (4, 5, 6), pour mettre à disposition de manière prédictive les données (P1,TMC), qui dépendent de l'émetteur et du lieu, du décodeur (3), ou bien l'unité de commande (7), lorsque le système de navigation (4, 5, 6) est désactivé, met à disposition de façon prédictive les données (P1, TMC), qui dépendent de l'émetteur et du lieu, du décodeur (3), au moyen d'une estimation de l'itinéraire à l'aide du trajet déjà parcouru.

8. Dispositif selon l'une des revendications 1 à 7,
**caractérisé en ce que** les données (TMC), qui dépendent du lieu, sont prises en compte par le système de navigation (4, 5, 6) lors de la détermination d'itinéraire (R').

9. Dispositif selon l'une des revendications 1 à 7,
**caractérisé par** un récepteur radio (11, 12, 13) pour la transmission de l'association, mémorisée dans la mémoire (8), de données de position vis-à-vis de données (P1) qui dépendent de l'émetteur.

10. Dispositif selon l'une des revendications 1 à 9,
**caractérisé en ce que** l'association de données de position vis-à-vis de données (P1, TMC) qui dépendent de l'émetteur est mémorisée dans le système de navigation (4, 5, 6).

11. Dispositif selon l'une des revendications 1 à 10,
**caractérisé en ce que** le système de navigation (4, 5, 6) comprend un décodeur GPS (5).

12. Procédé pour la sélection automatique d'émetteurs dont les signaux contiennent des données (P1, TMC) qui dépendent de l'émetteur et du lieu, en particulier d'émetteurs RDS, pour un récepteur destiné à fonctionner dans un véhicule automobile, comprenant les étapes de procédé suivantes :
- on prépare une association de données de position vis-à-vis de données (P1) qui dépendent de l'émetteur,
- on détermine des données de position qui correspondent à la position respective du véhicule automobile, et
- on met à disposition celles des données (P1, TMC), qui dépendent de l'émetteur et du lieu, des émetteurs qui sont pertinents pour les données de position déterminées,
**caractérisé en ce que**
parallèlement à la mise à disposition de celles des données (P1, TMC), qui dépendent de l'émetteur et du lieu, des émetteurs qui sont pertinents pour les données de position déterminées, on règle un émetteur ou une chaîne d'émetteurs quelconque(s) et on reproduit son signal audio.

13. Procédé selon la revendication 12,
**caractérisé en ce que** l'association préparée de données de position vis-à-vis de données (P1) qui dépendent de l'émetteur inclut plusieurs données (P1) qui dépendent de l'émetteur pour au moins une donnée de position.

14. Procédé selon la revendication 12 ou 13,
**caractérisé en ce que** l'on sélectionne tous les émetteurs susceptibles d'être reçus et on mémorise de façon intermédiaire la totalité des données (P1, TMC), qui dépendent de l'émetteur et du lieu, des émetteurs susceptibles d'être reçus.

15. Procédé selon la revendication 12,
**caractérisé en ce que** l'on sélectionne seul l'émetteur ou ceux des émetteurs qui est/sont pertinent(s) en raison de l'association des données de position vis-à-vis des données (P1, TMC) qui dépendent de l'émetteur et du lieu, et/ou qui est/sont pertinent(s) pour l'itinéraire.
